# EUROPEAN PATENT APPLICATION

(11) **EP 3 098 696 A1**
(43) Date of publication of application: **30.11.2016**
(21) Application number: 16170665.0
(22) Date of filing: 20.05.2016
(51) Int. Cl.: G06F 3/041, H05K 1/11, H05K 1/14, H05K 3/32

(54) **CONNECTION DEVICE**

(30) Priority: 28.05.2015 JP 2015108277
(71) Applicant: Alps Electric Co., Ltd., Tokyo 145-8501 (JP)
(72) Inventor: Ito, Takayuki, Tokyo, Tokyo 145-8501 (JP)
(74) Representative: Klunker . Schmitt-Nilson . Hirsch

(57) **Abstract**

A connection device includes a first flexible substrate (200) having a convex first surface (21) and a concave second surface (22), a plurality of first terminals (210) provided on the second surface and arranged in the bending direction of the second surface, a second flexible substrate (400) having a convex third surface (41) and a concave fourth surface (42), and a plurality of second terminals (410) provided on the third surface and arranged in the bending direction of the third surface, and connects the plurality of first terminals and the plurality of second terminals to each other with the second surface and the fourth surface opposed to each other. when the second surface and the third surface are flattened, the pitch of two of the plurality of first terminals is larger than the pitch of two of the plurality of second terminals that are connected to the two first terminals.

## Description

### BACKGROUND OF THE INVENTION

### 1. Field of the Invention

The present invention relates to a connection device that connects terminals provided on two flexible substrates having curved surface shapes.

### 2. Description of the Related Art

The importance of a touch panel conformed to a curved surface shape is increasing with reduction in thickness of liquid crystal displays and diversification of display forms. Japanese Unexamined Patent Application Publication No. 2013-114672 describes a touch module in which a case and a touch region are curved. Japanese Unexamined Patent Application Publication No. 2012-133428 describes a display device having a liquid crystal panel formed in a curved shape, and a touch panel bonded to a bonding layer on the liquid crystal panel. Japanese Unexamined Patent Application Publication No. 2014-075061 describes a touch panel in which a display device is provided on a curved convex surface of a glass film laminate for touch panel.

However, when connecting a flexible wiring substrate along a curved surface of a flexible substrate, the pitch of terminals on the flexible substrate and the flexible wiring substrate changes compared to that in the flat state according to the curvature, and therefore reliable connection is difficult. In particular, when connecting terminals using anisotropic conductive adhesive, reliable pressing force cannot be obtained due to terminal pitch mismatch, and sufficient electrical conduction may not be obtained.

### SUMMARY OF THE INVENTION

The present invention provides a connection device that can reliably connect terminals provided on two curved flexible substrates.

In an aspect of the present invention, a connection device includes a first flexible substrate having a first surface and a second surface, a second flexible substrate having a third surface and a fourth surface, a plurality of first terminals provided side by side on the second surface, and a plurality of second terminals provided side by side on the third surface. The first flexible substrate is bent such that the second surface is concave, the second flexible substrate is bent such that the third surface is convex, the second surface and the third surface are opposed to each other, and the first terminals and the second terminals are connected. When the second surface and the third surface are flat, the pitch in the bending direction of at least two of the plurality of first terminals is larger than the pitch in the bending direction of at least two of the second terminals connected to the at least two first terminals.

In the connection device in this aspect of the present invention, the pitch of the plurality of first terminals and the pitch of the plurality of second terminals can be made to correspond to each other with the first flexible substrate and the second flexible substrate each curved, and the plurality of first terminals and the plurality of second terminals can be reliably opposed to each other and connected.

It is preferable that the pitch in the flat state of the first terminals formed in a region of the second surface where the curvature is high when the first flexible substrate is bent be larger than the pitch in the flat state of the first terminals disposed in a region of the second surface where the curvature is low when the first flexible substrate is bent. In this case, the higher the curvature of the first flexible substrate, the more significantly the pitch of two first terminals decreases than in the flat state.

It is preferable that the pitch in the flat state of the second terminals formed in a region of the third surface where the curvature is high when the second flexible substrate is bent be smaller than the pitch in the flat state of the second terminals disposed in a region of the third surface where the curvature is low when the second flexible substrate is bent. In this case, the higher the curvature of the second flexible substrate, the more significantly the pitch of two second terminals increases than in the flat state.

When the second surface is flat, the pitch of some of the plurality of first terminals provided side by side that are located in the central part may be larger than the pitch of some of the plurality of first terminals that are located in both end parts. In this case, when the first flexible substrate is curved, the pitch of first terminals in the central part where the curvature is high decreases compared to that in the flat state more significantly, and the pitch of the entire plurality of first terminals can be uniformized.

When the third surface is flat, the pitch of some of the plurality of second terminals provided side by side that are located in the central part may be smaller than the pitch of some of the plurality of second terminals provided side by side that are located in both end parts. In this case, when the second flexible substrate is curved, the pitch of second terminals in the central part where the curvature is high increases compared to that in the flat state more significantly, and the pitch of the entire plurality of second terminals can be uniformized.

In another aspect of the present invention, a connection device includes a first flexible substrate having a first surface and a second surface, a second flexible substrate having a third surface and a fourth surface, a first terminal provided on the second surface, and a second terminal provided on the third surface. The first flexible substrate is bent such that the second surface is concave, the second flexible substrate is bent such that the third surface is convex, the second surface and the third surface are opposed to each other, and the first terminal and the second terminal are connected. When the second surface and the third surface are flat, the dimension in the bending direction of the first terminal is larger than the dimension in the bending direction of the second terminal.

In the above connection device, when the first flexible substrate and the second flexible substrate are bent and connected, the length of the first terminal and the length of the second terminal can be made to correspond to each other.

The connection device of the present invention is particularly effective when the plurality of first terminals and the plurality of second terminals are connected with anisotropic conductive adhesive. The plurality of first terminals and the plurality of second terminals are accurately opposed to each other, and sufficient pressing force can be applied to the anisotropic conductive adhesive and reliable electrical conduction can be obtained.

For example, the first flexible substrate is a touch sensor substrate, and the second flexible substrate is a flexible wiring substrate.

### BRIEF DESCRIPTION OF THE DRAWINGS

Fig. 1 is an exploded perspective view showing a connection device according to a first embodiment of the present invention;
Figs. 2A to 2C are enlarged explanatory diagrams showing a terminal connection part;
Figs. 3A to 3E are explanatory diagrams illustrating the pitch of terminals;
Figs. 4A to 4C are sectional views illustrating a terminal connection structure; and
Figs. 5A to 5C are sectional views illustrating a connection device according to a second embodiment of the present invention.

### DESCRIPTION OF THE PREFERRED EMBODIMENTS

Embodiments of the present invention will now be described with reference to the drawings. In the following description, the same reference signs will be used to designate the same components, and redundant description thereof will be omitted.

### First Embodiment

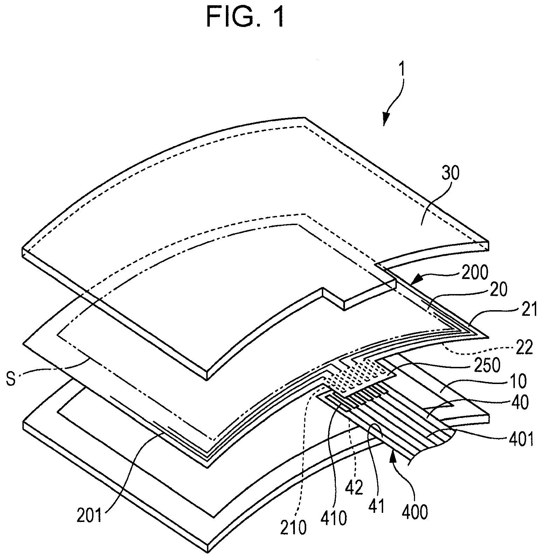

Fig. 1 shows an exploded perspective view of a touch panel display 1 to which a connection device according to a first embodiment of the present invention is applied.

The touch panel display 1 shown in Fig. 1 has a display panel 10 using liquid crystal or the like, a touch sensor substrate 20 provided on the top of the display panel 10, and a cover panel 30 provided on the top of the touch sensor substrate 20. The touch panel display 1 shown in Fig. 1 has a curved shape such that the cover panel 30 side is convex.

To make the curved touch panel display 1, the respective shapes of the display panel 10, the touch sensor substrate 20, and the cover panel 30 are curved. By stacking these, the curved shape of the touch panel display 1 is formed.

The touch sensor substrate 20 has a light-transmitting first flexible substrate 200 and light-transmitting wiring patterns 201. The wiring patterns 201 are electrically connected to a sensor pattern (not shown) provided through the length and breadth of the central part of the first flexible substrate 200, and are laid in the peripheral part of the first flexible substrate 200. First terminals 210 are connected to respective ends of the plurality of wiring patterns 201. A protruding portion 250 in which the plurality of first terminals 210 are disposed is provided on the edge of the first flexible substrate 200.

When the touch sensor substrate 20 is curved, the convex surface is referred to as the first surface 21, and the concave surface is referred to as the second surface 22. The plurality of first terminals 210 are provided on the second surface 22. The plurality of first terminals 210 are arranged in the bending direction of the second surface 22 at a predetermined pitch. The first terminals 210 have a width and a length necessary for the connection (electrical connection) to second terminals 410 described later.

A flexible wiring substrate 40 is connected to the touch sensor substrate 20. The flexible wiring substrate 40 is a wiring substrate for inputting and outputting signals between the touch sensor substrate 20 and an external circuit. The flexible wiring substrate 40 has a second flexible substrate 400 and wiring patterns 401. Second terminals 410 are connected to respective ends of the plurality of wiring patterns 401.

The flexible wiring substrate 40 is connected, in a curved state conforming to the touch sensor substrate 20, to the touch sensor substrate 20. When the flexible wiring substrate 40 is curved, the convex surface is referred to as the third surface 41, and the concave surface is referred to as the fourth surface 42. The plurality of second terminals 410 are provided on the third surface 41. The plurality of second terminals 410 are arranged in the bending direction of the third surface 41 at a predetermined pitch. The second terminals 410 have a width and a length necessary for the connection (electrical connection) to the first terminals 210.

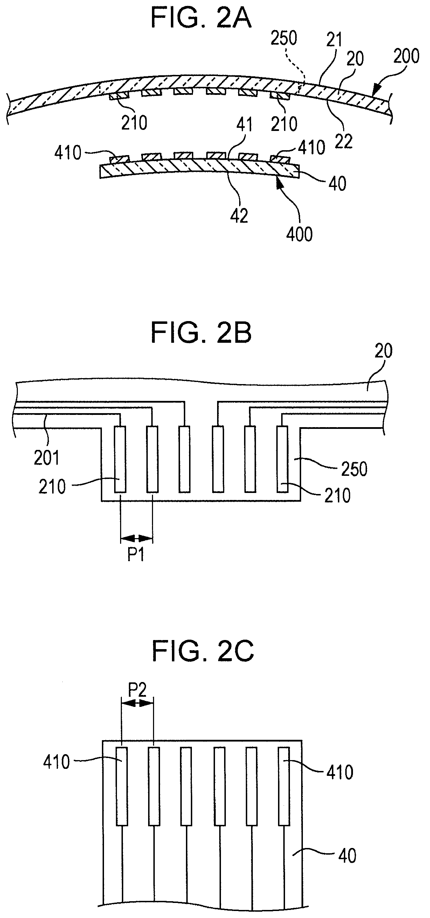

Figs. 2A to 2C are enlarged schematic views of a terminal connection part.

Fig. 2A shows an enlarged sectional view of a connection part between the first terminals 210 and the second terminals 410. For ease of illustration, in Fig. 2A, the touch sensor substrate 20 and the flexible wiring substrate 40 are shown separate. Fig. 2B shows a plan view of the first terminals 210, and Fig. 2C shows a plan view of the second terminals 410.

As shown in Fig. 2A, the touch sensor substrate 20 is curved such that the first surface 21 side is convex. The flexible wiring substrate 40 is also curved so as to conform to the curvature of the touch sensor substrate 20. The plurality of first terminals 210 are provided on the second surface 22 of the first flexible substrate 200, and the plurality of second terminals 410 are provided on the third surface 41 of the second flexible substrate 400. When connecting the terminals, the second surface 22 and the third surface 41 are opposed to each other, and the plurality of first terminals 210 and the plurality of second terminals 410 are connected to each other.

As shown in Figs. 2B and 2C, when the touch sensor substrate 20 and the flexible wiring substrate 40 are each curved, the pitch P1 in the bending direction of the plurality of first terminals 210 is substantially equal to the pitch P2 in the bending direction of the plurality of second terminals 410. That is, the pitch P1 of at least two of the plurality of first terminals 210 is substantially equal to the pitch P2 of at least two second terminals 410 connected to the at least two first terminals 210.

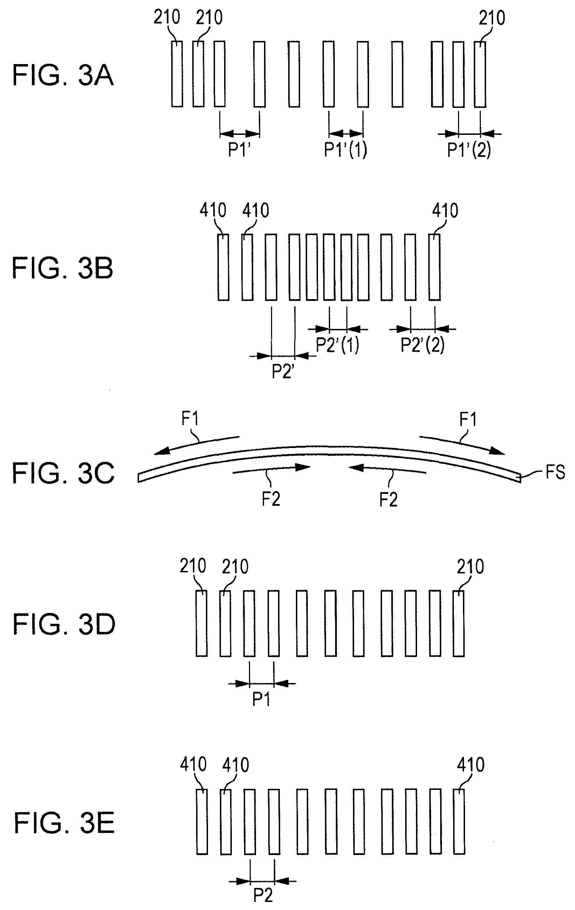

Figs. 3A to 3E are schematic diagrams illustrating the pitch of terminals. Fig. 3A illustrates the pitch P1' of the first terminals 210 when the second surface 22 is flattened, and Fig. 3B illustrates the pitch P2' of the second terminals 410 when the third surface 41 is flattened.

In the connection device according to this embodiment, when the second surface 22 of the first flexible substrate 200 and the third surface 41 of the second flexible substrate 400 are flattened, the pitch P1' of two of the plurality of first terminals 210 is larger than the pitch P2' of two of the plurality of second terminals 410 that are connected to the two first terminals 210.

Fig. 3C is a schematic diagram showing the tension and compression when a flexible substrate FS is curved.

When the flexible substrate FS is curved, tensile force F1 in the bending direction acts on the convex surface, and compressive force F2 in the bending direction acts on the concave surface. Thereby, the pitch of terminals provided on the convex surface is increased, and the pitch of terminals provided on the concave surface is decreased.

The change in pitch due to the curving of the flexible substrate FS corresponds to the curvature. That is, on the convex surface, the higher the curvature, the more significantly the pitch increases, and, on the concave surface, the higher the curvature, the more significantly the pitch decreases.

In view of such a property, in the connection device according to this embodiment, the pitches P1' and P2' are set such that when the second surface 22 of the first flexible substrate 200 and the third surface 41 of the second flexible substrate 400 are flat, the pitch P1' of the first terminals 210 is larger than the pitch P2' of the second terminals 410, and when the first flexible substrate 200 and the second flexible substrate 400 are curved, the pitch P1 of the first terminals 210 and the pitch P2 of the second terminals 410 are substantially equal.

Fig. 3D illustrates the pitch P1 of the first terminals 210 when the second surface 22 is curved, and Fig. 3E illustrates the pitch P2 of the second terminals 410 when the third surface 41 is curved. When the second surface 22 and the third surface 41 are curved, the pitch P1 and the pitch P2 are substantially equal. Therefore, the curved flexible wiring substrate 40 can be connected to the curved touch sensor substrate 20 with the plurality of first terminals 210 and the plurality of second terminals 410 reliably opposed to each other.

Here, the pitch P1' and the pitch P2' are set according to the curvature when the second surface 22 and the third surface 41 are curved. As described above, on the convex surface of a flexible substrate, the higher the curvature, the more significantly the pitch increases compared to that in the flat state, and, on the concave surface of the flexible substrate, the higher the curvature, the more significantly the pitch decreases compared to that in the flat state. Therefore, the higher the curvature, the smaller the pitch P1' in the flat state is set, and the higher the curvature, the larger the pitch P2' in the flat state is set.

As an example, in the plurality of first terminals 210 shown in Fig. 3A, the pitch P1'(1) of the central part is larger than the pitch P1'(2) of both end parts. In this example, on the second surface 22 on which the plurality of first terminals 210 are provided, the curvature of the central part of the plurality of first terminals 210 is higher than the curvature of both end parts. Therefore, by setting the pitch P1'(1) of the central part larger than the pitch P1'(2) of both end parts, the pitch P1 of the plurality of first terminals 210 when the second surface 22 is curved can be uniformized. The pitch P1' may gradually increase from both end parts to the central part.

In the plurality of second terminals 410 shown in Fig. 3B, the pitch P2'(1) of the central part is set smaller than the pitch P2'(2) of both end parts. In this example, on the third surface 41 on which the plurality of second terminals 410 are provided, the curvature of the central part of the plurality of second terminals 410 is higher than the curvature of both end parts. Therefore, by setting the pitch P2'(1) of the central part smaller than the pitch P2'(2) of both end parts, the pitch P2 of the plurality of second terminals 410 when the third surface 41 is curved can be uniformized. The pitch P2' may gradually decrease from both end parts to the central part.

When the curvature of a part of the first flexible substrate 200 in which the plurality of first terminals 210 are provided is substantially uniform, the pitch P1' of the plurality of first terminals 210 may be uniform. Similarly, when the curvature of a part of the second flexible substrate 400 in which the plurality of second terminals 410 are provided is substantially uniform, the pitch P2' of the plurality of second terminals 410 may be uniform.

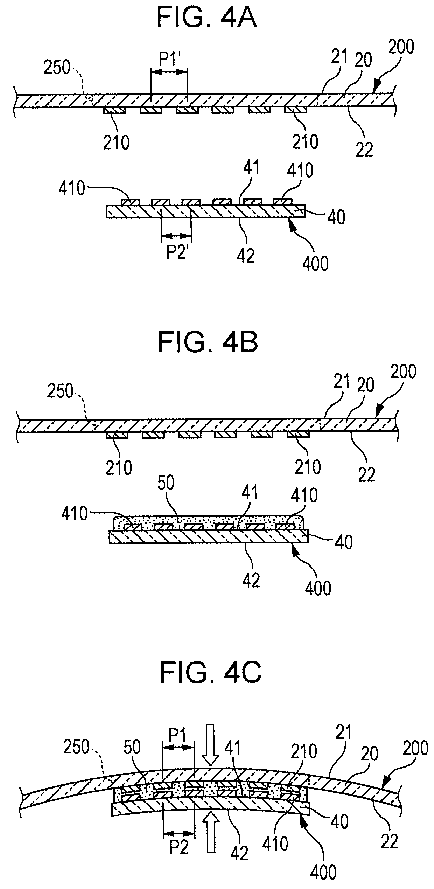

Figs. 4A to 4C are schematic sectional views illustrating a terminal connecting method.

First, as shown in Fig. 4A, a touch sensor substrate 20 and a flexible wiring substrate 40 are prepared. A plurality of first terminals 210 are provided on the second surface 22 of the first flexible substrate 200, and a plurality of second terminals 410 are provided on the third surface 41 of the second flexible substrate 400. When the flexible substrates 200 and 400 are flat, the pitch P1' of the plurality of first terminals 210 is larger than the pitch P2' of the plurality of second terminals 410.

Next, as shown in Fig. 4B, anisotropic conductive adhesive 50 is applied over the second terminals 410 of the flexible wiring substrate 40. The anisotropic conductive adhesive 50 may be applied over the first terminals 210 of the touch sensor substrate 20, or may be applied over both. Alternatively, a tape-shaped anisotropic conductive adhesive 50 is used.

Next, as shown in Fig. 4C, the second surface 22 and the third surface 41 are opposed to each other with the flexible substrates 200 and 400 curved, and the plurality of first terminals 210 and the plurality of second terminals 410 are connected. When the flexible substrates 200 and 400 are curved, the pitch P1 of the plurality of first terminals 210 corresponds to the pitch P2 of the plurality of second terminals 410, and the second surface 22 and the third surface 41 can be reliably opposed to each other.

Then, by pressing the connection part in this state, the anisotropic conductive adhesive 50 is made conductive in the pressing direction. Since the plurality of first terminals 210 and the plurality of second terminals 410 are reliably opposed to each other, the electrical connection between them can be accurately obtained with the anisotropic conductive adhesive 50.

### Second Embodiment

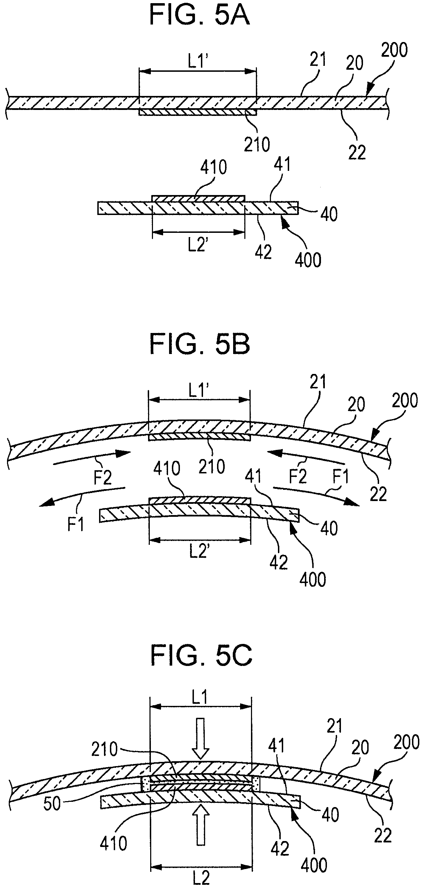

Figs. 5A to 5C are schematic sectional views illustrating a connection device according to a second embodiment.

The connection device according to the second embodiment differs from the connection device according to the first embodiment in the direction of bending. That is, in the second embodiment, the flexible substrates 200 and 400 are curved in the longitudinal direction of the first terminals 210 and the second terminals 410.

As shown in Fig. 5A, when the flexible substrates 200 and 400 are flat, the length L1' of the first terminals 210 is set larger than the length L2' of the second terminals 410. As shown in Fig. 5B, when the flexible substrates 200 and 400 are curved in the longitudinal direction of the first terminals 210 and the second terminals 410, compressive force F2 in the bending direction acts on the concave second surface 22, and tensile force F1 in the bending direction acts on the convex third surface 41. Thereby, the length L1' of the first terminals 210 provided on the second surface 22 is decreased, and the length L2' of the second terminals 410 provided on the third surface 41 is increased.

That is, although, in the flat state, the length L1' of the first terminals 210 is larger than the length L2' of the second terminals 410, in the curved state, the length L1 of the first terminals 210 approaches the length L2 of the second terminals 410. In this embodiment, the length L1' of the first terminals 210 and the length L2' of the second terminals 410 in the flat state are set such that the length L1 of the first terminals 210 and the length L2 of the second terminals 410 are substantially equal in the curved state.

Thereby, as shown in Fig. 5C, when the first terminals 210 and the second terminals 410 are connected in the curved state, they are connected in a state where their lengths L1 and L2 are substantially equal.

Although, in the second embodiment, the length L1' of the first terminals 210 and the length L2' of the second terminals 410 are set according to the curvature, when the bending direction is the width direction of the first terminals 210 and the second terminals 410, the width of the first terminals 210 and the width of the second terminals 410 may be set according to the curvature. In this case, the width of the first terminals 210 and the width of the second terminals 410 in the flat state may be set such that the width of the first terminals 210 and the width of the second terminals 410 are substantially equal in the curved state.

As described above, according to the embodiments, it is possible to provide a connection device that can reliably connect terminals provided on curved flexible substrates 200 and 400.

Although embodiments have been described above, the present invention is not limited to these embodiments. For example, while in the above-described embodiments, the flexible substrates 200 and 400 are bent in one direction, the same concept can be applied to a case where the flexible substrates 200 and 400 are bent in two directions. Those skilled in the art may add or remove components to or from the above-described embodiments, may make design changes to the above-described embodiments, and may combine features of the embodiments. Such changes are also included in the scope of the present invention without departing from the spirit of the present invention.

## Claims

1. A connection device comprising:
a first flexible substrate (200) having a first surface (21) and a second surface (22);
a second flexible substrate (400) having a third surface (41) and a fourth surface (42);
a plurality of first terminals (210) provided side by side on the second surface; and
a plurality of second terminals (410) provided side by side on the third surface,
wherein the first flexible substrate is bent such that the second surface is concave, the second flexible substrate is bent such that the third surface is convex, the second surface and the third surface are opposed to each other, and the first terminals and the second terminals are connected, and
wherein when the second surface and the third surface are flat, the pitch in the bending direction of at least two of the plurality of first terminals is larger than the pitch in the bending direction of at least two of the second terminals connected to the at least two first terminals.

2. The connection device according to Claim 1, wherein the pitch in the flat state of the first terminals formed in a region of the second surface where the curvature is high when the first flexible substrate is bent is larger than the pitch in the flat state of the first terminals disposed in a region of the second surface where the curvature is low when the first flexible substrate is bent.

3. The connection device according to Claim 1 or 2, wherein the pitch in the flat state of the second terminals formed in a region of the third surface where the curvature is high when the second flexible substrate is bent is smaller than the pitch in the flat state of the second terminals disposed in a region of the third surface where the curvature is low when the second flexible substrate is bent.

4. The connection device according to any one of Claims 1 to 3, wherein when the second surface is flat, the pitch of some of the plurality of first terminals provided side by side that are located in the central part is larger than the pitch of some of the plurality of first terminals provided side by side that are located in both end parts.

5. The connection device according to any one of Claims 1 to 4, wherein when the third surface is flat, the pitch of some of the plurality of second terminals provided side by side that are located in the central part is smaller than the pitch of some of the plurality of second terminals provided side by side that are located in both end parts.

6. A connection device comprising:
a first flexible substrate (200) having a first surface (21) and a second surface (22);
a second flexible substrate (400) having a third surface (41) and a fourth surface (42);
a first terminal provided (210) on the second surface; and
a second terminal provided (410) on the third surface,
wherein the first flexible substrate is bent such that the second surface is concave, the second flexible substrate is bent such that the third surface is convex, the second surface and the third surface are opposed to each other, and the first terminal and the second terminal are connected, and
wherein when the second surface and the third surface are flat, the dimension in the bending direction of the first terminal is larger than the dimension in the bending direction of the second terminal.

7. The connection device according to any one of Claims 1 to 6, wherein the plurality of first terminals and the plurality of second terminals are connected with anisotropic conductive adhesive (50).

8. The connection device according to any one of Claims 1 to 7, wherein the first flexible substrate is a touch sensor substrate (20), and the second flexible substrate is a flexible wiring substrate (40).
